# EUROPEAN PATENT APPLICATION

(11) **EP 1 832 339 A1**
(43) Date of publication of application: **12.09.2007**
(21) Application number: 05814263.9
(22) Date of filing: 09.12.2005
(51) Int. Cl.: B01J 19/00, B81B 1/00, B81C 3/00, G01N 37/00

(54) **SUPPORT UNIT FOR MICRO FLUID SYSTEM AND PROCESS FOR PRODUCING THE SAME**

(30) Priority: 09.12.2004 JP 2004356662
(71) Applicant: Hitachi Chemical Co., Ltd., Shinjuku-ku, Tokyo 163-0449 (JP)
(72) Inventor: AKAI, Kunihiko c/o Hitachi Chemical Co.,Ltd, Chikusei-shi Ibaraki 308-0857 (JP); KAWAZOE, Hiroshi c/o Hitachi Chemical Co., Ltd., Chikusei-shi Ibaraki 308-0857 (JP)
(74) Representative: HOFFMANN EITLE
(86) International application number: PCT/JP2005/022656
(87) International publication number: WO 2006/062191

(57) **Abstract**

The present invention relates to a microfluid-system-supporting unit, comprising a fixing layer formed on a substrate, a protective layer or a fixing layer, wherein part of at least one hollow filament in any shape is placed and fixed in the fixing layer. Thus, it provides a microfluid-system-supporting unit lower in surface irregularity even when there are multiple hollow filaments different in external diameter or the hollow filaments crosses each other and resistant to positional deviation of the hollow filament in the crossing regions, and a production method thereof.

## Description

### FIELD OF THE INVENTION

The present invention relates to a microfluid-system-supporting unit having a channel of hollow filament and a production method thereof.

### BACKGROUND OF THE INVENTION

Studies aimed at reducing the size of reaction systems and analyzers, an application of MEMS (microelectromechanical system) technology, is now in progress in the fields of chemistry and biochemistry, and research and development on monofunctional mechanical components (micromachines) such as micropump and microvalve are now in progress (see, for example, Shoji, "Chemical Industry", Kagaku Kogyo, April 2001, 52, 4, p.45-55 and Maeda, "Journal of Japan Institute of Electronics Packaging", Japan Institute of Electronics Packaging, Jan. 2002, 5, 1, p.25-26.).

Use of these functions in a microchannel circuit (system) for desired chemical reaction or analysis is studied increasingly eagerly, recently. Generally, such a system, when completed, is called a microreactor (microreactor system), or a micro total analysis system (µTAS). Recently, a chip-shaped substrate having a groove formed for example by etching on the surface for example of glass as the microchannel was proposed. The chip-shaped channel substrate is prepared by application of the photolithographic technology for production of semiconductors or printed wiring substrates.

On the other hand, microfluid-system-supporting units having a hollow filament as the channel are advantageous in that multilayer lamination of the channel layer (in the crosswise direction), which was difficult on the chip-shaped channel substrate, is easier and there is a wider flexibility in selecting the material for the channel hollowfilament, and thus, are useful in forming a complicated channel circuit. For example, a method of laminating hollow filaments in any shape placed on a film-shaped material with a similar film-shaped material was proposed for production of such a supporting unit (see, for example, Japanese Patent Application Laid-Open No. 2004-174701).

Japanese Patent Application Publication No. 50-9346 discloses an apparatus placing conductor wires while applying load and ultrasonic wave vibration, Japanese Patent Application Publication No. 7-95622 discloses an apparatus placing hollow filaments while applying load and irradiating laser beam, and Japanese Patent Application Laid-Open No. 2001-59910 discloses a wiring machine placing wires on an adhesive layer surface while applying load to wires (optical fibers), as the apparatuses for placing the hollow filaments.

### SUMMARY OF THE INVENTION

However, the lamination methods described above often resulted in generation of surface irregularity of the microfluid-system-supporting unit, when the specifications on the external diameter of the hollow filaments are different or when there are regions where the hollow filaments cross each other. Such surface irregularity caused a problem that, when an external force is applied onto the surface of the microfluid-system-supporting unit, the external force accumulates in the raised areas, leading to breakage or deformation of the hollow filament. Deformation of the hollow filament lead to deformation of the channel shape in the filament, causing problems such as restricted fluid flow and larger pressure drop. In addition, increase in the number of hollow filaments placed resulted in increase in the number of the intersections between hollow filaments and thus in the number of surface-irregular regions.

In addition, hollow filaments are often broken or deformed by the lamination pressure in the region of the intersection of hollow filaments by the lamination methods described above, and thus, a cushioning material should be used as needed during lamination.

Also when laminated by the lamination methods described above, a hollow filament having a larger external diameter is broken or deformed more frequently by the lamination pressure in the regions
where multiple hollow filaments different in external diameter are laminated, and thus, a cushioning material should be used as needed during lamination.

In addition, the hollow filaments were fixed less tightly and movable, causing a problem of positional deviation, in the hollow filament-crossing regions, where the substrate and the hollow filaments are in contact with each other with a smaller contact area.

An object of the present invention, which was made to solve the problems above, is to provide a microfluid-system-supporting unit lower in surface irregularity, more resistant to breakage or deformation in the hollow filament crossing regions and the regions where there are multiple hollow filaments different in external diameter during production of the microfluid-supporting unit than lamination methods, and resistant to positional deviation of the hollow filament in the crossing regions, and a production method thereof.

The present invention relates to (1) a microfluid-system-supporting unit, comprising a substrate and a fixing layer formed thereon, wherein part of at least one hollow filament is placed and fixed in any shape in the fixing layer.

The present invention also relates to (2) the microfluid-system-supporting unit according to (1), further comprising a protective layer covering at least part of the substrate and the fixing layer.

The present invention also relates to (3) a microfluid-system-supporting unit, comprising a protective layer and a fixing layer formed thereon, wherein part of at least one hollow filament is placed and fixed in any shape in the fixing layer.

The present invention also relates to (4) a microfluid-system-supporting unit, comprising an intermediate layer and a fixing layer formed thereon, wherein part of at least one hollow filament is placed and fixed in any shape in the fixing layer.

The present invention also relates to (5) a microfluid-system-supporting unit, wherein part of at least one hollow filament is placed and fixed in any shape in a fixing layer.

The present invention also relates to (6) the microfluid-system-supporting unit according to (1) or (2), wherein an intermediate layer is formed between the substrate and the fixing layer.

The present invention also relates to (7) the microfluid-system-supporting unit according to (3), wherein an intermediate layer is formed between the protective layer and the fixing layer.

The present invention also relates to (8) the microfluid-system-supporting unit according to any one of (4), (6), and (7), wherein the intermediate layer is a layer having an adhering potential, a layer having a buffering potential, or a layer having a releasing potential.

The present invention also relates to (9) the microfluid-system-supporting unit according to anyone of (1), (2), and (6), wherein the terminal of at least one hollow filament has an extra-length region sticking out of the substrate terminal.

The present invention also relates to (10) the microfluid-system-supporting unit according to any one of (2), (3), (6), and (7), wherein the terminal of at least one hollow filament has an extra-length region sticking out of the protective layer terminal.

The present invention also relates to (11) the microfluid-system-supporting unit according to any one of (1) to (10), wherein the terminal of at least one hollow filament has an extra-length region sticking out of the fixing layer terminal.

The present invention also relates to (12) the microfluid-system-supporting unit according to any one of (1) to (11), wherein at least part of the external wall of the intermediate region of at least one hollow filament is exposed out of the fixing layer.

The present invention also relates to (13) the microfluid-system-supporting unit according to (12), wherein at least part of the external wall of the intermediate region of at least one hollow filament is exposed out of the protective layer.

The present invention also relates to (14) the microfluid-system-supporting unit according to any one of (1) to (11), wherein the external wall of the intermediate region of at least one hollow filament is not exposed out of the fixing layer.

The present invention also relates to (15) the microfluid-system-supporting unit according to any one of (1) to (14), wherein the number of the hollow filaments is two or more.

The present invention also relates to (16) the microfluid-system-supporting unit according to (15), wherein the two or more hollow filaments are hollow filaments having two or more different external diameters.

The present invention also relates to (17) the microfluid-system-supporting unit according to any one of (1) to (16), wherein at least one hollow filament is placed in such a manner that it has a crossing region.

The present invention also relates to (18) the microfluid-system-supporting unit according to any one of (1) to (17), wherein the thickness of the microfluid-system-supporting unit in the region containing hollow filaments is larger than the external diameter of all hollow filaments.

The present invention also relates to (19) the microfluid-system-supporting unit according to any one of (1) to (18), wherein the thickness of the microfluid-system-supporting unit in the region containing hollow filaments is larger than the total thickness of the hollow filaments in the crossing region.

The present invention also relates to (20) the microfluid-system-supporting unit according to any one of (1) to (19), wherein the surface of the microfluid-system-supporting unit in the region containing hollow filaments is smooth.

The present invention also relates to (21) the microfluid-system-supporting unit according to any one of (1) to (20), wherein the fixing layer is a solidified varnish.

The present invention also relates to (22) the microfluid-system-supporting unit according to (21), wherein the varnish before solidification is fluid.

The present invention also relates to (23) the microfluid-system-supporting unit according to any one of (1) to (22), wherein the thickness of the microfluid-system-supporting unit in the region containing hollow filaments is 100 to 120% of the thickness of the microfluid-system-supporting unit in the region containing no hollow filament.

The present invention also relates to (24) the microfluid-system-supporting unit according to any one of (1) to (22), wherein the thickness of the microfluid-system-supporting unit in the region containing hollow filaments is 100 to 110% of the thickness of the microfluid-system-supportingunit in the region containing no hollow filament.

. The present invention also relates to (25) the microfluid-system-supporting unit according to any one of (1) to (22), wherein the thickness of the microfluid-system-supporting unit in the region containing hollow filaments is 100 to 105% of the thickness of the microfluid-system-supporting unitin the region containing no hollow filament.

The present invention also relates to (26) the microfluid-system-supporting unit according to any one of (1) to (22), wherein the thickness of the microfluid-system-supporting unit in the region containing hollow filaments is 100 to 103% of the thickness of the microfluid-system-supporting unit in the region containing no hollow filament.

The present invention also relates to (27) the microfluid-system-supporting unit according to any one of (1) to (26), wherein at least one hollow filament is placed in such a manner that it has a crossing region and the thickness of the microfluid-system-supporting unit in the crossing region is 100 to 120% of the thickness of the microfluid-system-supporting unit in the region other than the crossing region where the hollow filament is placed.

The present invention also relates to (28) the microfluid-system-supporting unit according to any one of (1) to (26) , wherein at least one hollow filament is placed in such a manner that it has a crossing region and the thickness of the microfluid-system-supporting unit in the crossing region is 100 to 110% of the thickness of the microfluid-system-supporting unit in the region other than the crossing region where the hollow filament is placed.

The present invention also relates to (29) the microfluid-system-supporting unit according to any one of (1) to (26) , wherein at least one hollow filament is placed in such a manner that it has a crossing region and the thickness of the microfluid-system-supporting unit in the crossing region is 100 to 105% of the thickness of the microfluid-system-supporting unit in the region other than the crossing region where the hollow filament is placed.

The present invention also relates to (30) the microfluid-system-supporting unit according to any one of (1) to (26), wherein at least one hollow filament is placed in such a manner that it has a crossing region and the thickness of the microfluid-system-supporting unit in the crossing region is 100 to 103% of the thickness of the microfluid-system-supporting unit in the region other than the crossing region where the hollow filament is placed.

The present invention also relates to (31) a method of producing a microfluid-system-supporting unit, comprising at least the following steps of:

(i) placing at least one hollow filament in any shape on a substrate,
(ii) covering a particular region including at least part of the hollow filament with a varnish, and
(iii) solidifying all or part of the varnish.
The present invention also relates to (32) a method of producing a microfluid-system-supporting unit, comprising at least the following steps of:

(i) placing at least one hollow filament in any shape on a substrate,
(ii) covering a particular region including at least part of the hollow filament with a varnish,
(iii) solidifying all or part of the varnish, and
(iv) forming a protective layer in a particular region.
   The present invention also relates to (33) a method of producing a microfluid-system-supporting unit, comprising at least the following steps of:

(v) covering a particular region of a substrate with a varnish
(vi) immersing at least part of at least one hollow filament in the varnish or floating at least one hollow filament on the varnish, and
(vii) solidifying all or part of the varnish.
   The present invention also relates to (34) amethodofproducing a microfluid-system-supporting unit, comprising at least the following steps of:

(v) covering a particular region of a substrate with a varnish,
(vi) immersing at least part of at least one hollow filament in the varnish or floating at least one hollow filament on the varnish,
(vii) solidifying all or part of the varnish, and'
(viii) forming a protective layer in a particular.region.
The present invent ion also relates to (35) a method of producing a microfluid-system-supporting unit, comprising at least the following steps of:

(ix) filling a varnish into a container,
(vi) immersing at least part of at least one hollow filament in the varnish or floating at least one hollow filament on the varnish,
(vii) solidifying all or part of the varnish, and
(x) removing at least part of the container.
The present invention also relates to (36) a method of producing a microfluid-system-supporting unit, comprising at least the following steps of:

(ix) filling a varnish into a container,
(vi) immersing at least part of at least one hollow filament in the varnish or floating at least one hollow filament on the varnish,
(vii) solidifying all or part of the varnish,
(x) removing at least part of the container, and
(viii) forming a protective layer in a particular region.
The present invention also relates to (37) a method of producing a microfluid-system-supporting unit, comprising at least the following steps of:

(ix) filling a varnish into a container,
(vi) immersing at least part of at least one hollow filament in the varnish or floating at least one hollow filament on the varnish,
(vii) solidifying all or part of the varnish,
(viii) forming.a protective layer on the surface of the solidified varnish, and
(x) removing at least part of the container.
The present invention also relates to (38) the method of producing a microfluid-system-supporting unit according to (31) or (32), further comprising a step of forming an intermediate layer between the substrate and at least one hollow filament before placing the at least one hollow filament on the substrate.

The present invention also relates to (39) the method of producing a microfluid-system-supporting unit according to (33) or (34), further comprising a step of forming an intermediate layer on the substrate before coating a particular region of the substrate with the varnish.

The present invention also relates to (40) the method of producing a microfluid-system-supporting unit according to any one of (35) to (37), further comprising a step of forming an intermediate layer on the surface of a container before filling the varnish in the container.

The present invention also relates to (41) the method of producing a microfluid-system-supporting unit according to any one of (38) to (40), further comprising a step of placing all or part of the at least one hollow filament in any shape on the intermediate layer.

The present invention also relates to (42) the method of producing a microfluid-system-supporting unit according to any one of (38) to (41), wherein the intermediate layer is a layer having an adhering potential, a layer having a buffering potential, or a layer having a releasing potential.

The present invention also relates to (43) the method of producing a microfluid-system-supporting unit according to any one of (31) to (34), wherein a bank is formed and a particular region is covered with the varnish.

The present invention also relates to (44) the method of producing a microfluid-system-supporting unit according to any one of (38) to (43), further comprising a step of removing at least part of the intermediate layer after all or part of the varnish is solidified.

The present invention also relates to (45) the method of producing a microfluid-system-supporting unit according to any one of (31) to (34), (38), (39), and (42) to (44), further comprising a step of removing at least part of the substrate after all or part of the varnish is solidified.

The present invention also relates to (46) the method of producing a microfluid-system-supporting unit according to any one of (33) to (45), wherein the hollow filament previously fixed in any shape is immersed in the varnish or floated on the varnish.

The present invention also relates to (47) the method of producing a microfluid-system-supporting unit according to (46), wherein the hollow filament is placed and fixed previously on the substrate or the intermediate layer of the substrate having it.

The present invention also relates to (48) the method of producing a microfluid-system-supporting unit according to any one of (33) to (37), wherein the hollow filament is fixed in any shape in the varnish.

The present invention also relates to (49) the method of producing a microfluid-system-supporting unit according to any one of (31) to (48), wherein the varnish is fluid.

The present invention also relates to (50) the method of producing a microfluid-system-supporting unit according to any one of (31) to (49), further comprising a step of removing the varnish.

This application claims priority from Japanese Patent ApplicationNo. 2004-356662 filed on December, 9 2004, the disclosure of which is incorporated by reference herein.

### BRIEF DESCRIPTION OF THE DRAWINGS

Fig. 1(a) is a schematic plan view illustrating the first step in step (i) in the first embodiment of the present invention, and Fig. 1(b), a schematic cross-sectional view thereof along the line Ib-Ib indicated by the arrow in Fig. 1(a).
Fig. 2(a) is a schematic plan view illustrating the second step in step (i) in the first embodiment of the present invention, and Fig. 2 (b), a schematic cross-sectional view thereof along the line IIb-IIb indicated by the arrow in Fig. 2(a).
Fig. 3(a) is a schematic cross-sectional view illustrating step (ii) in the first embodiment of the present invention; Fig. 3 (b), a schematic cross-sectional view illustrating the step (iii) in the first embodiment of the present invention; and Fig. 3(c), a schematic cross-sectional view illustrating the step of removing the varnish after the step shown in Fig. 3(b).
Fig. 4(a) is a schematic plan view illustrating the first step in step (i) in the second embodiment of the present invention, and Fig. 4 (b), a schematic cross-sectional view thereof along the line IVb-IVb indicated by the arrow in Fig. 4(a).
Fig. 5(a) is a schematic cross-sectional view illustrating the second step in step (i) in the second embodiment of the present invention, and Fig. 5 (b), a schematic cross-sectional view thereof along the line Vb-Vb indicated by the arrow in Fig. 5(a).
Fig. 6(a) is a schematic plan view illustrating step (ii) in the second embodiment of the present invention; Fig. 6(b), a schematic cross-sectional view illustrating the step (iii) in the second embodiment of the present invention; and Fig. 6(c), a schematic cross-sectional view illustrating the step of removing the varnish after the step shown in Fig. 6(b).
Fig. 7(a) is a schematic plan view illustrating the first step in step (i) in the third embodiment of the present invention, and Fig. 7 (b), a schematic cross-sectional view thereof along the line VIIb-VIIb indicated by the arrow in Fig. 7(a).
Fig. 8(a) is a schematic plan view illustrating the second step in step (i) in the third embodiment of the present invention, and Fig. 8(b), a schematic cross-sectional view thereof along the line VIIIb-VIIIb indicated by the arrow in Fig. 8(a).
Fig. 9(a) is a schematic cross-sectional view illustrating step (ii) in the third embodiment of the present invention; Fig. 9 (b), a schematic cross-sectional view illustrating the step (iii) in the third embodiment of the present invention; and Fig. 9(c), a schematic cross-sectional view illustrating the step of removing the varnish after the step shown in Fig. 9(b).
Fig. 10 (a) is a schematic cross-sectional view illustrating step (ii) in the fourth embodiment of the present invention; Fig. 10 (b), a schematic cross-sectional view illustrating the step (iii) in the fourth embodiment of the present invention; and Fig. 10 (c), a schematic cross-sectional view illustrating the step of removing the varnish after the step shown in Fig. 10 (b).
Fig. 11(a) is a schematic cross-sectional view illustrating step (ii) in the fifth embodiment of the present invention; Fig. 11 (b), a schematic cross-sectional view illustrating the step (iii) in the fifth embodiment of the present invention; Fig. 11(c), a schematic cross-sectional view illustrating the step of removing the varnish after the step shown in Fig. 11(b); and Fig. 11(d), a schematic cross-sectional view illustrating the step (iv) in the fifth embodiment of the present invention.

### (EXPLANATION OF REFERENCE NUMERALS)

1: Substrate
11: Adhesive layer
2, 201 to 208, and 211 to 218: Hollow filament
3: Varnish
31: Solidified varnish
32: Region where the varnish is solidified
4: Protective layer
5: Bank
6: NC wiring machine

### DESCRIPTION OF THE PREFERRED EMBODIMENTS

Favorable embodiments and steps of the present invention will be described below with reference to drawings. In description below, the same or similar regions are indicated by the same or similar numerals. However, the drawings are only schematic, and it should be understood that the relationship between thickness and planar dimension, the ratio in thickness of respective layers, and others may be different from actual values. Thus, the specific thickness and dimension should be determined, with reference to the following description. Needless to say, there are some parts different from each other in dimension and ratio in the following drawings.

Any one of various commercially available tubes different in composition may be used as the hollow filament, and a tube of any material may be selected according to applications. Examples thereof include organic materials such as polyvinyl chloride resins (PVC), polyvinylidene chloride resins, polyvinyl acetate resins, polyvinylalcohol resins (PVA), polystyrene resins (PS), acrylonitrile-butadiene-styrene copolymers (ABS), polyethylene resins (PE), ethylene-vinyl acetate copolymer resins (EVA), polypropylene resins (PP), poly-4-methylpentene resins (TPX), polymethyl methacrylate resins (PMMA), polyether ether ketone resins (PEEK), polyimide resins (PI), polyether imide resins (PEI), polyphenylene sulfide resins (PPS), cellulose acetate, ethylene tetrafluoride resins (PTFE), propylene tetrafluoride hexafluoride resins (FEP), ethylene tetrafluoride-perfluoroalkoxyethylene copolymers (PFA), ethylene tetrafluoride-ethylene copolymers (ETFE), ethylene trifluoride chloride resins (PCTFE), vinylidene fluoride resins (PVDF), polyethylene terephthalate resins (PET), polyamide resins (such as nylon, PA), polyacetal resins (POM), polyphenyleneoxide resins (PPO), polycarbonate resins (PC), polyurethane resins, polyester elastomers, polyolefin resins, and silicone resins; inorganic materials such as glass, quartz, and carbon; and the like.

The internal and external diameters of the hollow filament according to the present invention may be determined properly according to applications. In particular, the internal diameter is preferably approximately 0.05 to 1.5 mm, because fluid in an amount in the order of milliliter (mL) to microliter (µL) is fed therein. For preparation of hollow filament having such a diameter, for example, a material such as polyimide (PI), polyether ether ketone (PEEK), polyether imide (PEI), polyphenylene sulfide (PPS), or an ethylene tetrafluoride-perfluoroalkoxyethylene copolymer (PFA) is particularly preferable. A hollow-filament internal diameter of less than 0.05 mm may make the interfacial resistance between the hollow-filament internal wall face and the fluid unnegligibly large. The hollow filament is preferably chemically inert, if the fluid flowing in the hollow filament is reactive chemically.

The hollow filament is preferably light transparent if the fluid flowing in the hollow filament is photoirradiated for photochemical reaction or spectroscopic analysis. The light transparency is arbitrary according to application, but preferably 80% or more, more preferably 90% or more, at a desirable wavelength. The hollow fiber may be made transparent, for example, by making a particular region of the hollow filament and also the fixing layer, substrate, or protective layer described below transparent or by making particular region of the hollow filament transparent by irradiating the region with light.

The present invention is characterized in that part of at least one hollow filament is placed and fixed in any shape in a fixing layer. The material for the fixing layer is preferably a varnish. Examples of the materials for the varnish include epoxy resins, melamine resins, cyanate ester resins, phenol resins, silicone resins, gel substances, natural rubbers, silicone rubbers and the like. The varnish is preferably fluidal before solidification, and the fixing layer is a fixing layer obtained by solidifying of all or part of the varnish.

The varnish preferably solidifies by heat or light. The term solidification means general liquid-solid transition, photo-hardening or thermocuring reaction, gelation, reduction of varnish flowability by reduction of solvent or decrease of varnish temperature, or the like. For example, a varnish based on a high-molecular weight synthetic rubber or a silicone resin is favorable.

Examples of the high-molecular weight synthetic rubbers for the varnish include isobutylene polymers such as Vistanex MML-120 (trade name) manufactured by Tonex Co., Ltd., acrylonitrile-butadiene rubbers such as Nipol N1432 (trade name) manufactured by Zeon Corporation, chlorosulfonated polyethylenes such as Hypalon (registered trade name) 20 manufactured by E.I. du Pont de Nemours and Company, and the like. A crosslinking agent may be added as needed to the material.

The silicone resin varnish is preferably a silicone adhesive containing a silicone rubber of high-molecular weight polydimethylsiloxane or polymethylphenylsiloxane having a silanol group at the terminal and a silicone resin, such as methyl silicone resin or methylphenyl silicone, as principal components. The resin may be crosslinked in any way for adjustment of its aggregation potential. The crosslinking may be performed, for example, by addition reaction of silane, alkoxy condensation reaction, acetoxy condensation reaction, or radical reaction for example with a peroxide. Commercially available products of the adhesive agent include YR3286 (trade name, manufactured by GE Toshiba Silicones Co. , Ltd.), TSR1521 (tradename, manufactured by GE Toshiba Silicones Co., Ltd.), DKQ9-9009 (trade name, manufactured by Dow Corning), and the like.

Examples of the photosensitive varnishes include varnishes of dry- film resists and solder-resist inks used as the etching resists for printed circuit boards, photosensitive build-up materials for printed circuit boards, and the like. Specific examples thereof include H-K440 (trade name, manufactured by Hitachi Chemical Co., Ltd.), Probimer manufactured by Ciba-Geigy Corp., and the like. In particular, the photobia materials used in the build-up wiring board application withstand the conditions in the production process of printed wiring boards and in the component-mounting step of using a solder. Any one of these materials may be used, if it is a composition containing a copolymer or monomer having a photocrosslinkable functional group and/or a composition containing a photocrosslinkable and thermal crosslinkable functional group and a thermal polymerization initiator.

Examples of the other varnishes include alicyclic epoxy resins such as epoxy resin, brominated epoxy resin, rubber-modified epoxy resin, and rubber-dispersed epoxy resin; bisphenol A-based epoxy resins, and acid-modified derivatives of these epoxy resins, and the like. In particular, unsaturated acid-modified derivatives of these epoxy resins are used favorably, when the resin is hardened by photoirradiation. Examples of the unsaturated acids include maleic anhydride, tetrahydrophthalic anhydride, itaconic anhydride, acrylic acid, methacrylic acid, and the like. The modified product is prepared by allowing an unsaturated carboxylic acid to react with the epoxy groups of an epoxy resin at a blending ratio of 1 or less equivalence. Other favorable examples thereof include thermosetting materials such as melamine resin and cyanate ester resin, combinations thereof with a phenol resin, and the like. In addition, an agent for giving flexibility may be added, and examples thereof include acrylonitrile-butadiene rubber, natural rubber, acrylic rubber, SBR, carboxylic acid-modified acrylonitrile-butadiene rubber, carboxylic acid-modified acrylic rubber, crosslinked NBR particles, carboxylic acid-modified crosslinked NBR particles, and the like. It is possible to provide the hardened product with various properties, while preserving the basic performance in light hardening and thermosetting efficiency, by adding one of the various resin components above. For example, combination of an epoxy resin and a phenol resin gives a hardened product favorable in electric resistance. When a rubber component is blended it is possible to provide the hardened product with toughness and to make the surface of the hardened product easily roughened by surface treatment with an oxidative drug solution.

It is also possible to add commonly-used additives (polymerization stabilizer leveling agent, pigment, dye, etc.) to the varnish. A filler may also be blended. Examples of the fillers include inorganic fine particles such as of silica, fused silica, talc, alumina, hydrated alumina, barium sulf ate, calcium hydroxide, Aerojil, and calcium carbonate; organic fine particles such as of powdery epoxy resin and powdery polyimide particle; powdery polytetrafluoroethylene particles, and the like. The filler may be treated previously with a coupling agent. These materials are dispersed by a known blending method, for example, in a kneader, ball mill, bead mill, or three-roll mill.

Alternatively, a gel material may be used as the varnish. Commercially available products thereof include ultrasoft urethane resins (manufactured by Exseal Corporation), silicone elastomer SYLGARD 184 (trade name, manufactured by Dow Corning Asia), a photosolidifying material Technovit 2000LC (trade name, manufactured by Heraeus Kulzer), and the like.

The amount and the viscosity of the varnish are determined arbitrarily according to applications. For example, a more fluid varnish penetrates into the space between multiple hollow filaments, when there are multiple hollow filaments present. It also penetrates into the intersection region, thus favorably, fixing these hollow filaments further tightly.

The varnish-coating method is selected, for example, from automatic film applicator, curtain coating, spray coating, spin coating, application, and the others. In particular when a thick film is desirable, it is preferably to form a bank and thus to prevent leaching of the varnish out of a particular range. When the varnish is more fluid, the varnish penetrates, for example, into the space between the hollow filament and the substrate and among crossed hollow filaments, preventing problems, for example of residual air bubble.

In covering a particular region with a varnish, it is possible to increase the tightness of the hollow filament therein for example by placing the system under reduced pressure. For example when a particular region is covered with the varnish, the varnish penetrates into the spaces between hollow filaments and between the hollow filament and the substrate or adhesive layer, even in the areas of complicated pattern or high-density intersection, and increases the tightness of the hollow filament therein. It is also possible to obtain the same effect by placing the varnish under reduced pressure before solidification. When a particular region is covered with the varnish, it is also possible to reduce the amount of air bubbles in the varnish by placing the varnish under reduced pressure before solidification of the varnish. For example, a two-liquid epoxy resin varnish, often allows containment of air bubbles in the varnish in the step of solidification. When such a varnish is used, it is also possible to reduce the amount of the air bubbles, for example, by placing the varnish under reduced pressure, before the particular region is coated with the varnish.

The microfluid-system-supporting unit according to the present invention may have a substrate additionally and a fixing layer formed on the substrate. The material, shape, size, and others of the substrate are determined according to its application. The range in thickness suitable for the substrate varies according to the purpose and desirable function of the substrate.

For example, favorably used when the substrate demands electric insulating property are epoxy resin plates and polyimide resin plates used for printed wiring boards, polyimide films such as Kapton (registered trade name) film manufactured by E.I. du Pont de Nemours and Company and PET film such as Lumirror (registered trade name) film manufactured by Toray Industries, Inc. used for flexible printed wiring boards, and the like. The thickness of the substrate (film thickness) is preferably 0.05 mm or more. Alternatively, use of a metal foil or plate such as of aluminum (A1), copper (Cu), stainless steel, or titanium (Ti) is preferable, for improvement of the heat-releasing efficiency of the first supporting plate. Alternatively for a substrate demanding light-transmitting property, selection of an inorganic material plate or film such as of glass or quartz plate or an organic material plate such as of a polycarbonate or acrylic resin is preferable.

The thickness of the substrate (film thickness) is preferably 0.5 mm or less. A so-called flexible circuit board or printed circuit board having a metal pattern, for example of steel, formed on the surface by etching, plating, or the like maybe used as the substrate. Thus, it is possible to form a terminal or a circuit carrying mounted parts and elements including micromachine, heating element, piezoelectric element, various sensors of temperature, pressure, deformation, vibration, voltage, magnetic field, and others; electronic parts such as resistance, capacitor, coil, transistor, and IC; and optical parts such as semiconductor laser (LD), light-emitting diode (LED) and photodiode (PD), and thus to simplify the system easily.

Fixation of the hollow filament in the fixing layer of substrate or solidified varnish has an advantage that it is possible to control operation of the unit in various environments different in ambient temperature, electric field, or magnetic field, more easily than in the free state. The fixation is advantageous during chemical reaction or chemical analysis, in particular in a micro reaction and analysis systems. It also has an advantage that it is easy to align and connect the follow fibers to other parts and placing multiple hollow filaments densely in a narrow space.

The hollow filament may be placed on a substrate by any known method, for example, by fusing the follow filament on the substrate (melting and fixing at least part of the hollow filament or the substrate, and part of the hollow fiber may be then embedded in the substrate), forming it on the intermediate layer described below (the hollow filament maybe embedded then in the intermediate layer), forming it on a substrate or intermediate layer with an adhesive, forming a dent pattern for example by etching or plating on the position of the substrate where the hollow filament is placed and placing the hollow filament therein, forming a dent pattern for example by etching, plating, or photopatterning on the position of the substrate where the hollow filament is placed and placing the hollow filament therein, and the like. Examples of the adhesives include commonly commercially available adhesives and various material described above for the substrate and the varnish.

Specifically, commercially available machines such as NC wiring machine are applicable as the wiring machines. Examples thereof include machines wiring on a conductor under application of load and ultrasonic wave vibration, machines wiring under application of load and irradiation of laser beam, machines wiring under application of load on the wire (optical fiber) and wiring it on the adhesive layer face, and the like.

The NC wiring machine allows output control of the ultrasonic wave vibration and the load as it is numerically controlled, and thus, it is possible to control the wiring pattern of the hollow filament accurately by using such an NC wiring machine. Specifically, the hollow filament is placed under application of load and vibration by ultrasonic wave, while the NC wiring machine is moved horizontally, relative to the substrate.

Alternatively, the microfluid-system-supporting unit according to the present invention may have a fixing layer and a protective layer, and a fixing layer formed on the protective layer. Yet alternatively, it may have a fixing layer, a protective layer, and a substrate, wherein the protective layer covers at least part of the fixing layer and the substrate.

The protective layer is formed, for example, by surface modification of the solidified varnish, coating, adhesion, or lamination of various materials, or the like. Specific materials for the protective layer include various materials for the substrate or varnish listed above.

A layer with an adhering potential (hereinafter, referred to as adhesive layer) may be formed on the surface of the fixing layer as an intermediate layer, for easier placement of the hollow filament on the substrate. Specifically, an intermediate layer may be formed between the substrate and the fixing layer, between the protective layer and the fixing layer, or on one surface of the fixing layer. The "intermediate layer" may not be present between two layers.

Favorable examples of the adhesive layers include No. 500 tape manufactured by Nitto Denko Corporation, acrylic resin-based double-sided adhesive tapes such as VHB A-10, A-20, and A-30 (trade name, manufactured by 3M), silicone-based adhesives such as silicone-based adhesive sheet 6A05AW (trade name) manufactured by Toho Sangyo, and the like.

If the substrate and the fixing layer are to be separated, the intermediate layer preferably has a releasing potential. For example, materials such as fluoroplastics and silicone resins are used favorably. Specific examples thereof include a fluorine-based releasing agent Mold Sput MR-K681 (trade name, manufactured by Asahi Glass), Frelease (manufactured by Neos Company Limited), silicone-based releasing agent KF412SP (trade name, manufactured by Shin-Etsu Chemical Co., Ltd), and the like.

The materials described above for the varnish are also usable for the adhesive layer. When a photosensitive resin is used, an adhesive layer is formed, for example, by roll coating, curtain coating, dip coating of a liquid resin, or by lamination of an insulation resin formed on the support film.

Specific examples thereof include photobia film BF-8000 manufactured by Hitachi Chemical Co., Ltd., and the like.

A layer having an adhering potential, a releasing potential, or a buffering potential may be used as the intermediate layer. For example various materials described above for the substrate may be used for the layer having the buffering potential, and other materials for the layer include low-hardness or low-elasticity materials superior in cushioning property such as gels, rubbers, and foams of a silicone resin or a soft urethane resin; engineering plastics superior in chemical resistance and physical properties including friction- and abrasion-resistance, chemically resistance, oil resistance, and gas-barrier property, such as PET, PEEK, and PPS; metals; and the like.

The cross-sectional shape of the hollow filament may be selected arbitrarily according to applications. For example, when a wiringmachine, in which the hollow filament is wired in a particular pattern with a wiring head as it is rotated or moved in the X and Y directions during production, is used, the cross-sectional shape of the follow filament is preferably circular or elliptic without any inflection point, for prevention of clogging or scratching for example by vibration duringwiring in the apparatus. Alternatively, for example, a polygonal shape such as triangle or quadrangle, a continuous freely drawn shape, or a combination thereof may be used.

The cross-sectional channel shape of the hollow filament may be selected arbitrarily according to applications. For example, the shape shown above for the external cross-sectional shape of the hollow filament may be used. Normally, it is a shape drawn continuously with a single stroke. Supply of mixed fluid containing insoluble fine particles such as blood often results in clogging and irregular flow because of precipitation of fine particles and restricted liquid flow, and thus, a shape without any inflection point is preferable. The shape is more preferably elliptic, and still more preferably circular, because such a shape is resistant to the irregular liquid flow.

The number of the hollow channels in the cross-sectional area of the hollow filament may be selected arbitrarily according to applications. Normally, the number of the channel is one in one hollow filament, but multiple channels may be formed when multiple fluids are preferably handled with a single hollow filament. For example, hollow filaments (lumen type) having multiple hollow channels (multiple holes) for use for example in endoscopes are used favorably. The cross-sectional channel shapes thereof may be different from each other, and the size and the shape thereof are selected arbitrarily according to applications. The shape described above as the cross-sectional shape for the hollow filament may be used.

The terminal of at least one hollow filament preferably extends out of the terminal of the substrate, protective layer or fixing layer, and has an extra-length region. Thus, the channel of the microfluid-system-supporting unit can be connected easily to the channel in an external apparatus or an external part.

At least part of the external wall in the intermediate region of at least one hollow filament is preferably exposed out of the fixing layer or protective layer. It is thus possible to supply light and heat to any intermediate region of the hollow filament easily from outside and to control the temperature and the reaction and monitor the channel and fluid. Use of a highly transparent material as the constituent material such as hollow filament or substrate makes optical monitoring easier. Alternatively, use of a high-thermal conductivity material allows easier application of heat. It also makes processing of the external wall of hollow filament easier, for example for installation of a sensor, piezoelectric device, or the like and processing of hole, slit, or the like. The hole-processing allows insertion of a sensor such as thermocouple into the channel, injection and collection of fluid, and others. The hole-processing may be replaced with branching of a channel.

The external wall in the intermediate region of at least one hollow filament may not be exposed out of the fixing layer. Thus, the hollow filament is more tightly retained in the fixing layer. It also prevents direct application of external force on the hollow filament and inhibits deformation of the hollow filament. It also inhibits or buffers transmission of light or heat to the hollow filament. For example by selecting a suitable material such as low-thermal conductivity, high-heat resistance, or light-blocking material for the fixing layer or the substrate according to applications, it is possible to inhibit heat transmission and photoirradiation onto the channel and make the hollow filament less vulnerable to ambient environment, independently of the material used for the hollow filament.

There may be only one hollow filament, but preferably, there are two or more filaments. The material and the shape thereof may be selected arbitrarily, respectively according to applications.

The two or more hollow filaments may be made of two or more hollow filament different in external diameter.

At least one hollow filament may be placed as it has a crossing region, and a hollow filament may cross the same hollow filament or the other hollow filament. Thus, even a complicated fluid circuit containing multiple channels does not demand a large space, allowing increase in density of the hollow filament. It is also possible to obtain a microfluid-system-supporting unit having smaller surface irregularity, even when the hollow filaments are crossed or have different external diameters.

The thickness of the region of the microfluid-system-supporting unit containing the hollow filament is preferably larger than the external diameter of all hollow filaments and the total thickness of the hollow filaments in the crossing region. It is possible in this way to obtain a microfluid-system-supporting unit having a surface-flattened fixing layer. The flattened surface means that the surface is under no influence of the shape of the hollow filament.

The thickness of the microfluid-system-supporting unit in the region containing hollow filaments is preferably 100 to 120% of the thickness of the microfluid-system-supporting unit in the region containing no hollow filament. It is more preferably 100 to 110%, still more preferably 100 to 105%, and particularly preferably 100 to 103%.

When the hollow filament is so placed that at least one hollow filament has a crossing region, the thickness of the microfluid-system-supporting unit in the crossing region is preferably 100 to 120% of the thickness of the microfluid-system-supporting unit in the region other than the crossing region having hollow filaments. It is more preferably 100 to 110%, still more preferably 100 to 105%, and particularly preferably 100 to 103%.

The substrate end face or the substrate surface opposite to the face having the fixing layer may be covered partially with the fixing layer. The fixing layer top face, the fixing layer end face, the substrate end face, or the substrate face opposite to the fixing layer face may be covered with a protective layer at least partially. The fixing layer end face or the fixing layer bottom face may be covered with a protective layer at least partially. It is thus possible to obtain a microfluid-system-supporting unit containing more hollow filaments immobilized, by forming a fixing layer on each face of the substrate. In addition, presence of a protective layer prevents decomposition of the fixing layer or the substrate and hides the properties of the fixing layer and the substrate such as tackiness.

Hereinafter, the method of producing a microfluid-system-supporting unit will be described with reference to drawings.

The present invention relates to a method of producing a microfluid-system-supporting unit, comprising steps at least (i), (ii) and (iii):

(i) placing at least one hollow filament in any shape on a substrate,
(ii) covering a particular region including at least part of the hollow filament with a varnish, and
(iii) solidifying all or part of the varnish.
   The method may comprise the following step (iv) after the step (iii):

(iv) forming a protective layer in the particular region.
In the production method in an embodiment of the present invention shown in Fig. s 1 to 3, hollow filaments are placed directly on the substrate without an adhesive layer formed.

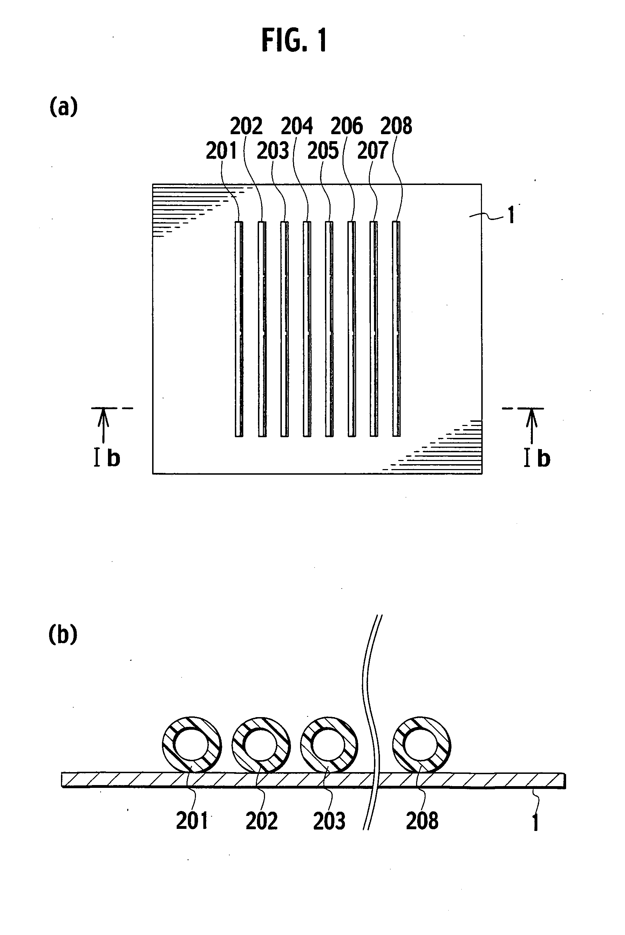

Fig. 1(a) is a schematic plan view illustrating the first step in step (i) of placing at least one hollow filament in any shape on a substrate of the first embodiment, while Fig. 1 (b) is a schematic cross-sectional view of the unit along the line Ib-Ib indicated by the arrow in Fig. 1(a). InFig. 1, firsthollowfilaments 201 to 208 are placed in parallel, directly on the substrate 1 with their terminals within the range of the substrate terminal.

Although not shown in Fig. 1, for example, an NC wiring machine may be used in placing the hollow filament as described above.

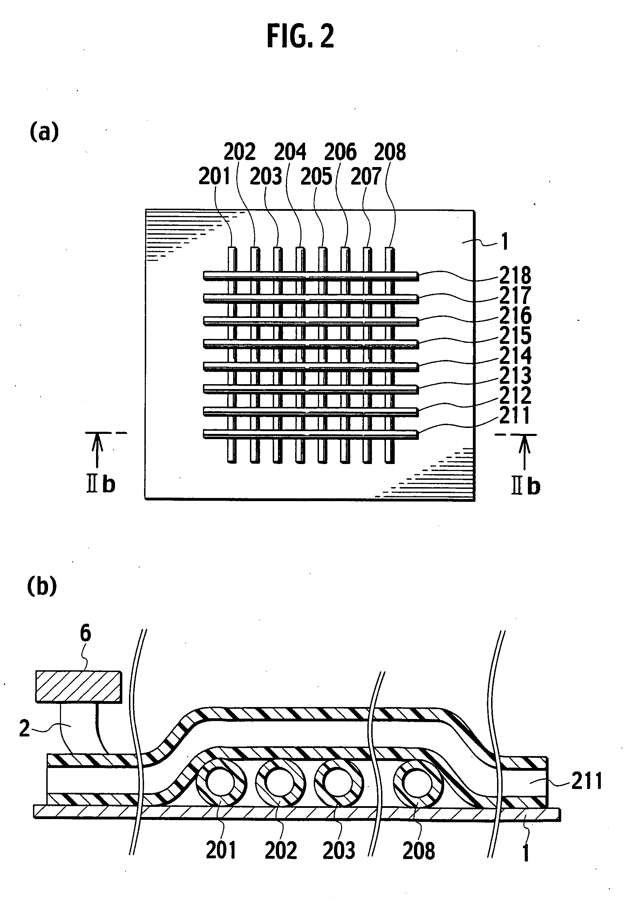

Then, other second hollow filaments 211 to 218 are placed crosswise on the first hollow filaments 201 to 208 previously placed, with their terminals within the range of the substrate terminal. Fig. 2 (a) is a schematic plan view illustrating the the second step in step (i), while Fig. 2(b) is a schematic cross-sectional view thereof along the line IIb-IIb indicated by the arrow in Fig. 2 (a).

For example, an NC wiring machine 6 may be used in placing the filaments, although not shown in the paln view of Fig. 2(a). However, the load and the ultrasonic wave vibration applied by the NC wiring machine 6 are preferably eliminated in the region where the first hollow filaments 201 to 208a previously placed and the second hollow filaments 211 to 218 to be newly placed are crossing each other. Elimination of the load and/or ultrasonic wave vibration applied in the region close to the crossing regions between the first hollow filaments 201 to 208 and the second hollow filaments 211 to 218 reduces the stress on each hollow filament and prevents breakdown of the hollow filament.

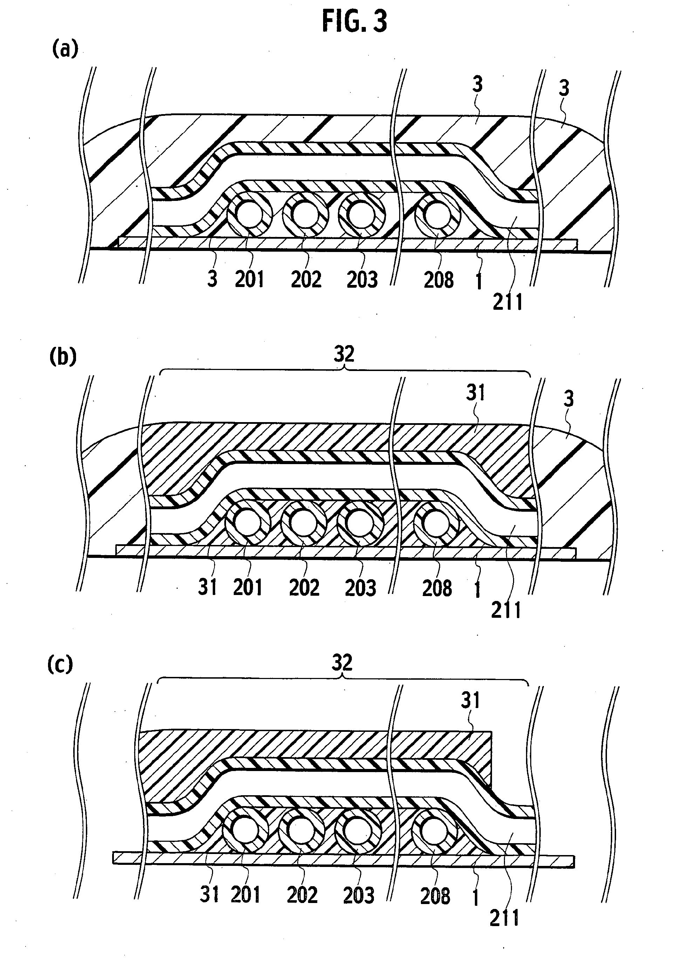

Fig. 3 (a) shows the step (ii) of covering a particular region including at least part of the hollow filament with a varnish, and the crossing region between the first hollow filaments 201 to 208 and the second hollow filaments 211 to 218 previously placed is then coated with a varnish 3.

The varnish 3 is then solidified. The solidified varnish 31 represents the fixing layer. Fig. 3(b) is a schematic cross-sectional view illustrating an example of the step (iii) of solidifying all or part, i.e., a particular solidification region 32, of the varnish; the solidification method is selected properly according to the kind of the varnish; and the varnish is solidified, for example, by application of hear or light or by removal of solvent. Especially when light is used, it is possible to solidify only a particular solidification region 32 by photoirradiating only the region and give a solidified varnish 31, as shown in Fig. 3(b).

Fig. 3 (c) is a schematic cross-sectional view illustrating the step of removing the varnish shown in Fig. 3(b).

Common methods of removing unsolidified varnishes are used favorably for removal of the unsolidified varnish. When the varnish is more fluid, it is possible to remove the varnish by decantation, by holding the microfluid-system-supporting unit as it is inclined or upside down. Alternatively, the varnish may be removed, by suctioning with syringe, pipette, aspirator or the like, wiping with an absorbent such as paper or sponge, washing with solvent or water, blowing with gas or liquid, or scooping or removal with spoon, spatula, blade, or the like.

Alternatively when the varnish is less fluid, the methods used for less fluid varnishes may be used, and when the varnish is particularly lower in flowability, a method of scraping with a blade may be used. Alternatively, combination of the methods above may be used for removing the varnish.

The methods described above for removing the unsolidified varnish may be used for removal of the solidified varnish. In particular when the varnish is less fluid and harder, the varnish may be removed by breakdown by laser, ion beam, or the like, scraping with a blade such as of cutter, lathe, or drill, pulverization for example with a hammer, or solubilization with a chemical. Alternatively, combination of the methods above may be used for removal of the solidified varnish.

The hollow filament should not be damaged during removal of the varnish. The varnish may be removed more easily when the hollow filament is release-finished. The hollow filament may be release-finished for example by application of a releasing agent, surface modification by plasma treatment, or the like. The releasing agents described above as the materials for the intermediate layer may be used as the releasing agents. Alternatively, the materials superior in release characteristics described above such as silicone-based materials, fluorine resins, or materials containing the same may be used as the materials for the follow filament. Combination of a material superior in release characteristics and a releasing agent is favorable.

In the second to fifth embodiments shown in Fig.s 4 to 11, an adhesive layer is formed on a substrate, and hollow filaments are placed on the adhesive layer. The adhesive layer is formed on the surface of the substrate almost in the same shape and in the same size. The NC wiring machine 6 is not shown in Fig.s 5 (a) and 8 (a).

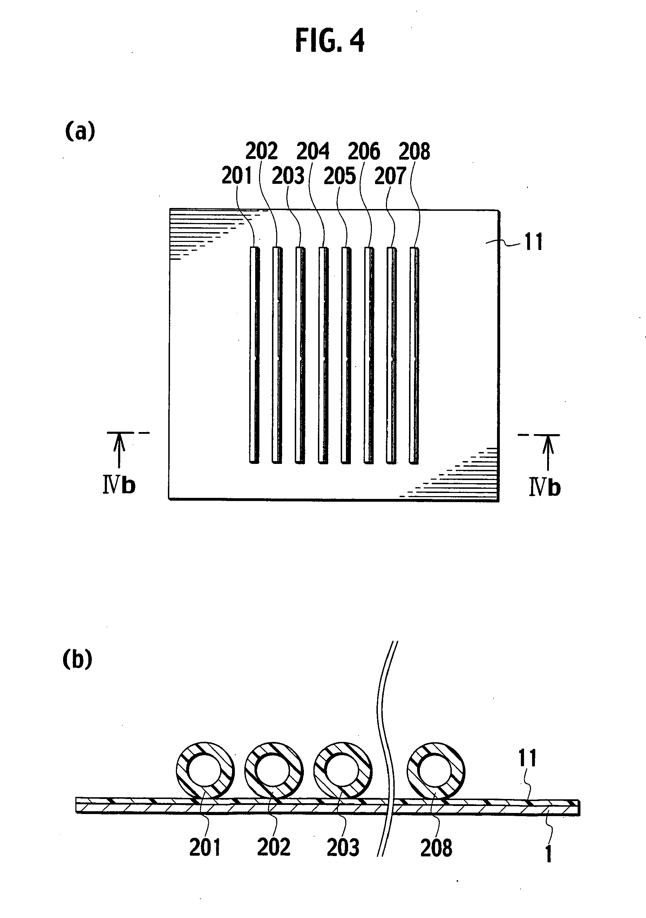

Fig. 4(a) is a schematic plan view illustrating the first step of step (i) in the second embodiment of the present invention, while Fig. 4(b) is schematic cross-sectional view thereof along the line IVb-IVb indicated by the arrow in Fig. 4(a).

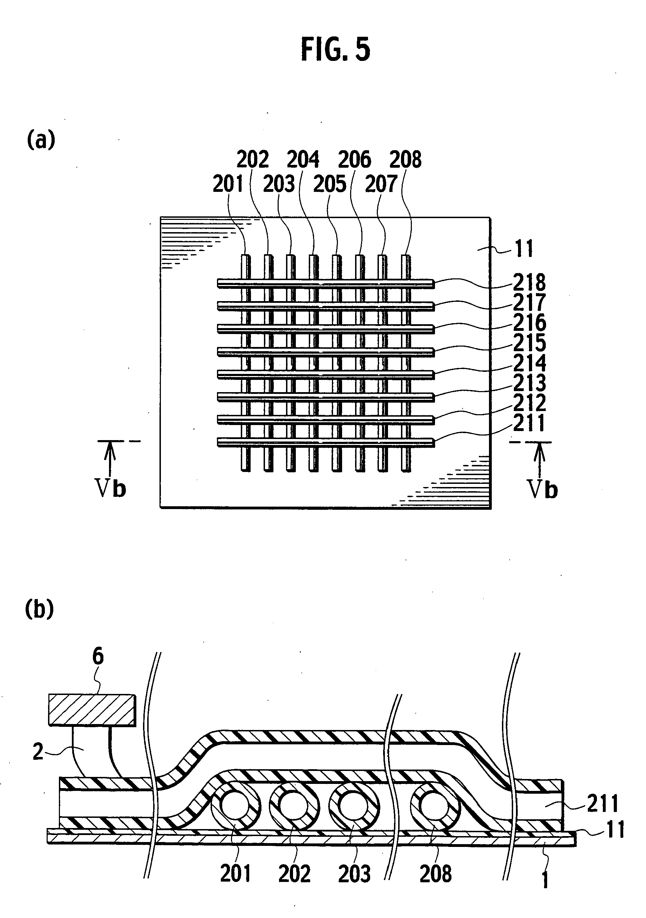

Fig. 5(a) is a schematic plan view illustrating the second step of step (i), while Fig. 5(b) is a schematic cross-sectional view thereof along the line Vb-Vb indicated by the arrow in Fig. 5(a).

In Fig. 4, an adhesive layer 11 is formed on a substrate 1, and first hollow filaments 201 to 208 are placed on the adhesive layer 11 with their terminal within the range of the substrate terminal. In Fig. 5, second hollow filaments 211 to 218 are placed crosswise on the first hollow filaments 201 to 208 previously placed with their terminal within the range of the substrate by a terminal NC wiring machine 6.

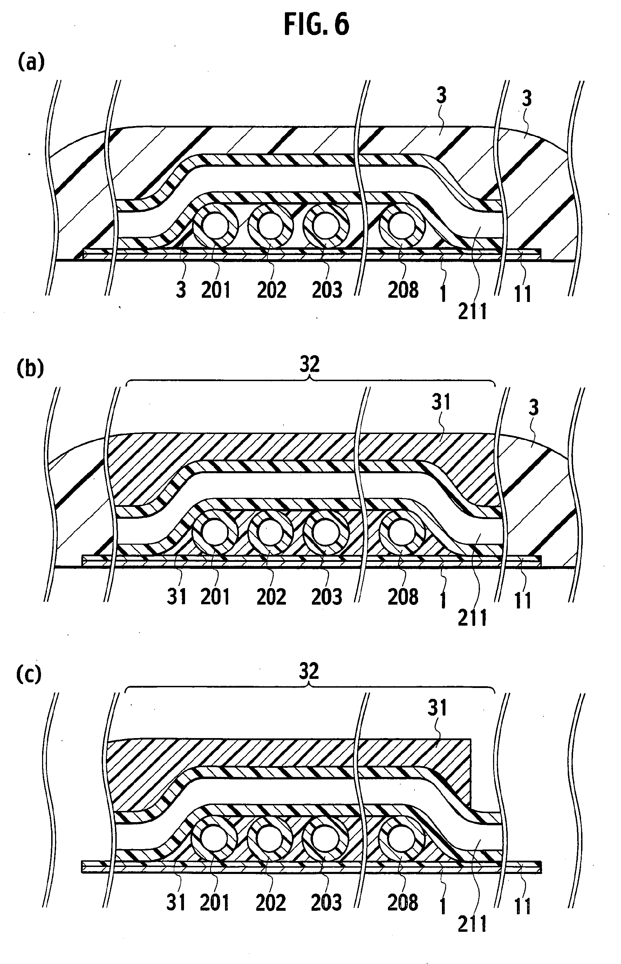

Fig. 6 (a) is schematic cross-sectional view illustrating the step (ii), and Fig. 6 (b), step (iii), while Fig. 6 (c) is a schematic cross-sectional view illustrating the step of removing the varnish after step in Fig. 6(b).

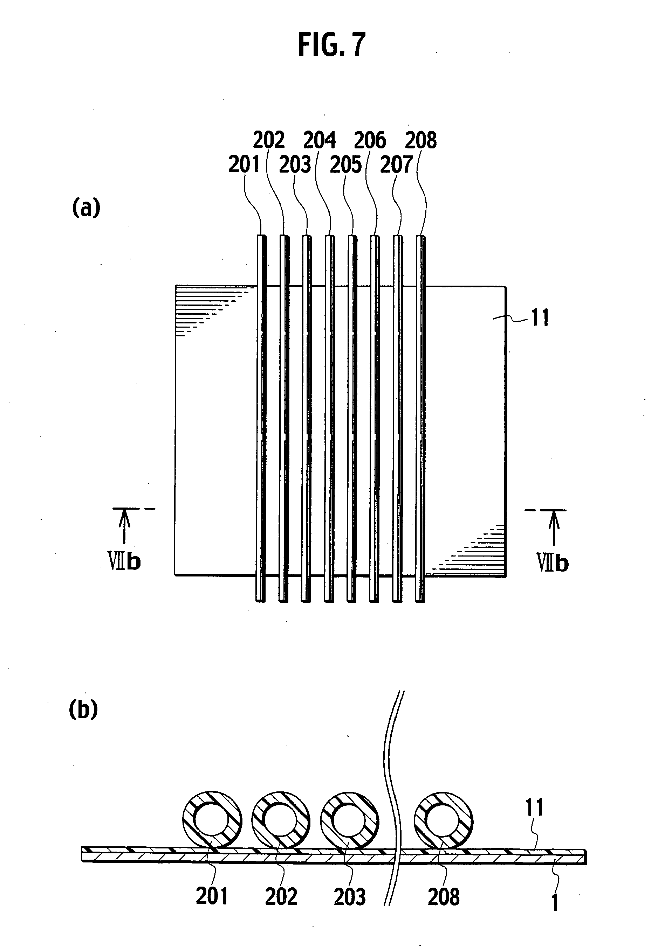

Fig. 7(a) is a schematic plan view illustrating the first step of step (i) in the third embodiment of the present invention, while Fig. 7 (b) is a schematic cross-sectional view thereof along the line VIIb-VIIb indicated by the arrow in Fig. 7(a).

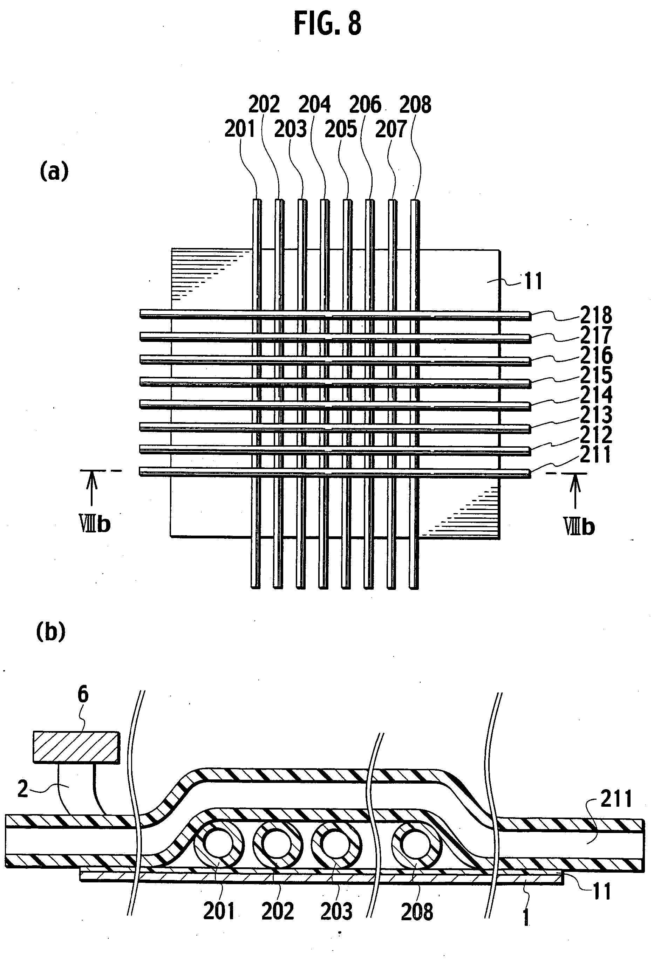

Fig. 8 (a) is a schematic plan view illustrating the second step of step (i), while Fig. 8(b) is a schematic cross-sectional view along the line VIIIb-VIIIb indicated by the arrow in Fig. 8 (a). In Fig. s 7 and 8, the terminal of each hollow filament is so placed that it extends out of the substrate terminal and has an extra-length region.

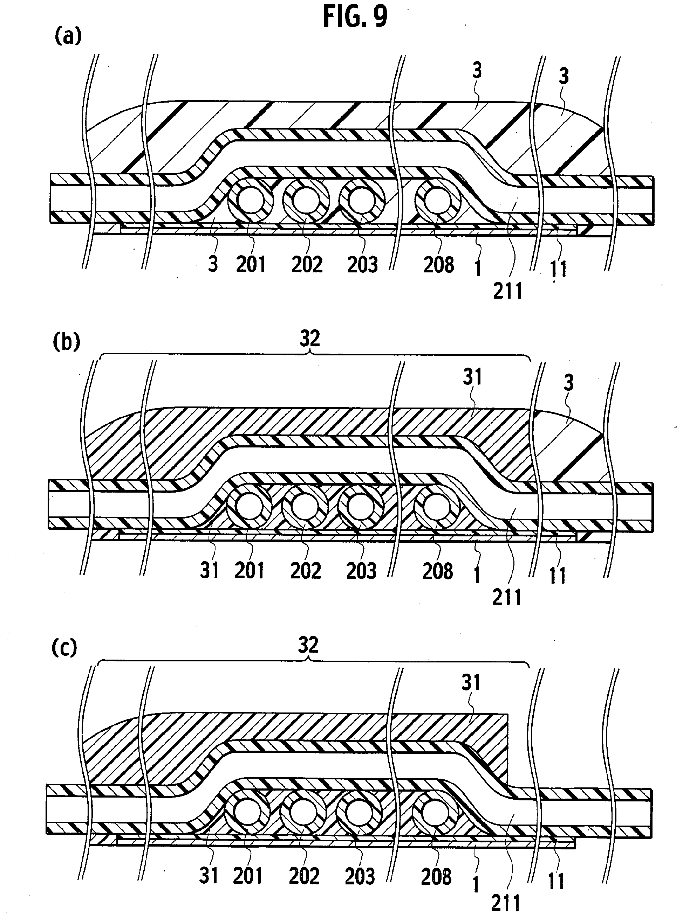

Fig. 9(a) is a schematic cross-sectional view illustrating the step (ii), and Fig. 9(b), step (iii), while Fig. 9(c) is a schematic cross-sectional view illustrating the step of removing the varnish after step in Fig. 9 (b). In Fig. 9, the solidified varnish 31 (fixing layer) covers part of the substrate end face (left end face in Fig.).

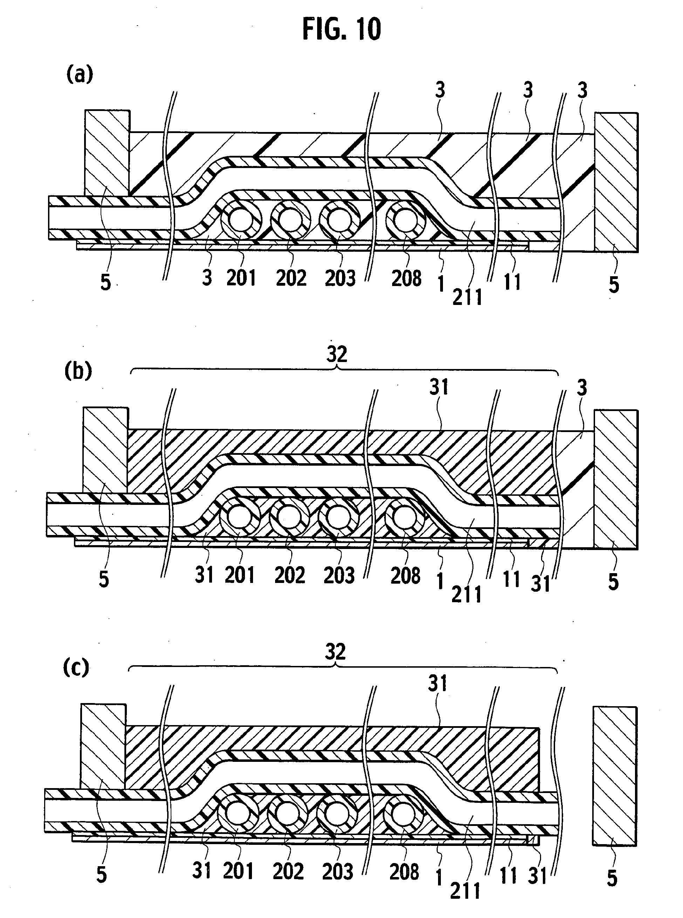

Fig. 10 is a schematic cross-sectional view illustrating part of the fourth embodiment of the production method according to the present invention. Fig. 10 (a) is a schematic cross-sectional view illustrating the step (ii) Fig., and Fig. 10(b), step (iii), while Fig. 10(c) is a schematic cross-sectional view illustrating the step of removing the varnish after the step in Fig. 10 (b). In Fig. 10, the hollow filament is so placed that the terminal of the hollow filament extends out of the substrate terminal and has an extra-length region; a bank 5 is formed; and a varnish 3 is poured inside the bank (see Fig. 10 (a)). The bank 5 may be formed outside or inside the terminal of the hollow filament. As in Fig. 10 (b), the varnish in a particular varnish region 32 is solidified, and the particular region is covered with a fixing layer by removing the varnish as shown in Fig. 10(c). It is thus possible to obtain a microfluid-system-supporting unit having its hollow filament fixed in a fixing layer only in a particular desirable region.

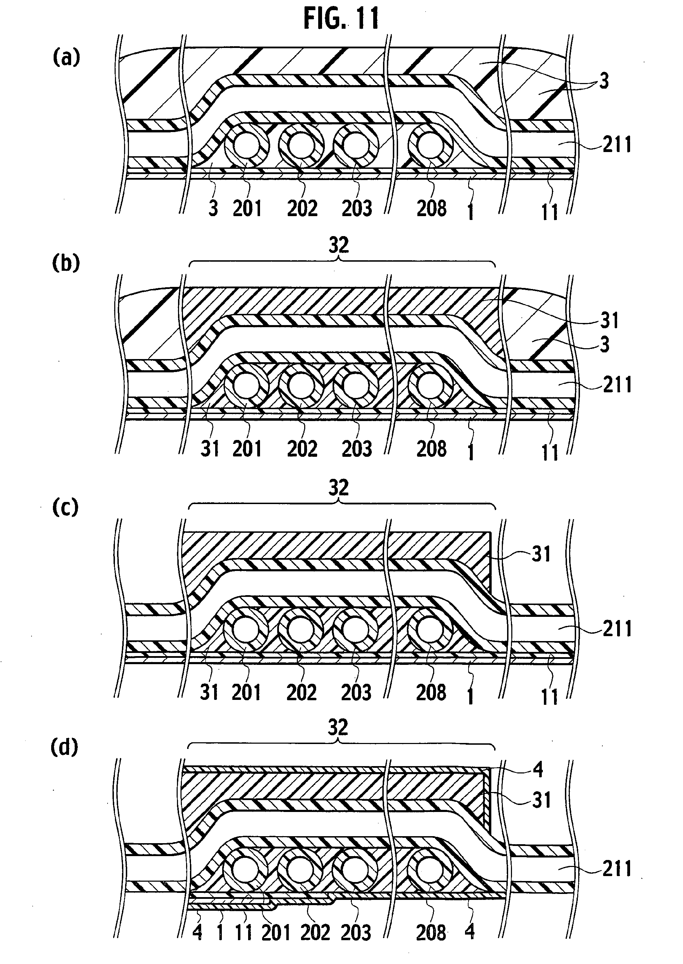

Fig. 11 is a schematic cross-sectional view illustrating part of the production method in the fifth embodiment of the present invention. Fig. 11 (a) shows the step (ii) in the fifth embodiment; Fig. 11(b), the step (iii); Fig. 11(c), the step of removing the varnish after the step in Fig. 11 (b) ; and Fig. 11 (d), the step (iv) of forming a protective layer. In step (iv), a protective layer 4 is formed on the surface of the solidified varnish 31 (fixing layer).

As in Fig. 11 (d), a protective layer 4 may be formed not only on the top and side faces of the solidified varnish 31 (fixing layer), but also on any of the surface of the substrate 1, the surface of the adhesive layer 11, and the surface of the hollow filament-sided fixing layer exposed after the substrate 1 and the adhesive layer 11 are separated.

The present invention relates to a method of producing a microfluid-system-supporting unit, comprising the following steps at least (v), (vi) and (vii):

(v) covering a particular region on a substrate with a varnish,
(vi) immersing at least part of at least one hollow filament in the varnish or floating at least one hollow filament on the varnish, and
(vii) solidifying all or part of the varnish.
   The method may include the following step (viii) after the step (vii):

(viii) forming a protective layer in a particular region.
   It is thus possible to obtain a microfluid-system-supporting unit resistant to decomposition of the substrate, the intermediate layer and the fixing layer or easier in handling because the properties of the substrate, intermediate layer and fixing layer such as tackiness are hidden. It is also possible to obtain a microfluid-system-supporting unit favorable for a particular application, by providing the protective layer with chemical resistance, rigidity, or low hygroscopicity.

The present invention relates to a method of producing a microfluid-system-supporting unit, comprising the following steps at least (ix), (vi), (vii) and (x):

(ix) filling a varnish into a container,
(vi) immersing at least part of at least one hollow filament in the varnish or floating at least one hollow filament on the varnish,
(vii) solidifying all or part of the varnish, and
(x) removing at least part of the container.
The method may include the following step (viii) between the step (vii) and the step (x), or after the step (x):

(viii) forming a protective layer in a particular region.
   It is thus possible to obtain a microfluid-system-supporting unit resistant to decomposition of the fixing layer or easier in handling while the properties of the fixing layer such as tackiness is hidden.

As described above in Fig. 4(a) of second embodiment, the production method according to the present invention may include additionally a step of forming an intermediate layer between the substrate and at least one hollow filament before placing the at least one hollow filament on the substrate.

Alternatively, the production method according to the present invention may include additionally a step of forming an intermediate layer on a substrate before covering a particular region of the substrate with a varnish.

Yet alternatively, the production method according to the present invention may include additionally a step of forming an intermediate layer on the surface of a container before filling a varnish into the container.

Alternatively, the production method according to the present invention may include additionally a step of placing all or part of at least one hollow filament on an intermediate layer in any shape.

The intermediate layer is then, preferably a layer having an adhering potential, a layer having a buffering potential, or a layer having a releasing potential.

The production method according to the present invention may include additionally a step of removing at least part of the substrate or at least part of the intermediate layer after all or part of the varnish is solidified. It is thus possible to select the substrate or the intermediate layer freely independently of the use environment. For example, it is possible to produce a microfluid-system-supporting unit with a substrate and an intermediate layer cheaper and lower in heat resistance, even when a uni t f or use under high temperature condition is desirablyproduced. Because it is possible to expose only a region needed for the fixing layer, it is possible to expose the external wall of the hollow filament by removing the region of the substrate when part of the external wall of the hollow filament is exposed to the substrate side in the fixing layer. For example, even when a hard metal or a thick resin plate is used as the substrate, it become possible to process the fixing layer directly afterward, by removing a particular region.

In the production method according to the present invention, a hollow filament previously fixed in any shape may be immersed in a varnish or floated on a varnish. Thus, there is no need for moving or feed the varnish itself in the production step. It is thus possible to use a varnish lower in handling efficiency such as that veryhigher in flowabilityorresistant totemperature control. It is also possible to fix the hollow filament in any shape in the fixing layer even if it has a sterically bulky region.

The hollow filament may be placed and fixed previously on the substrate or in the intermediate layer on the substrate.

In the production method according to the present invention, the hollow filament may be fixed in the varnish in any shape. It is thus possible to form a microfluid-system-supporting unit easily without placing the hollow filament in any shape for example in a wiring machine.

### EXAMPLES

Hereinafter, the present invention will be described with reference to Examples, but it should be understood that the present invention is not restricted by these Examples.

### (Example 1)

A double-faced adhesive tape 9415PC (trade name, manufactured by Sumitomo 3M) having a thickness of 0.25 mm was bonded onto one face of a PET film (substrate) having a thickness of 0.05 mmpreviously cut into a piece of approximately 150 mm in length and 200 mm in width as the intermediate layer having an adhering potential in a roll laminator. A special double tube manufactured by Nitta Moore Company (internal layer: ETFE, external layer: PA11, internal diameter: 1.00 mm, external diameter: 1.50 mm) was made available, and the hollow filament above was placed and fixed on the adhesive layer surface of the double-faced tape in a matrix shape at intervals of 20 mm in the length and width directions. Then, all terminals of the hollow filament in the area approximately 100 mm from the substrate terminal were exposed as the extra-length region. A double-faced tape was bonded at four corners on the other face of the substrate PET film and also into a plastic tray (internal dimension: 200 mm × 150 mm × 30 mm). The extra-length region remained extended out of the edge of the tray.

Then, a major agent silicone elastomer SYLGARD 184 (trade name, manufactured by Dow Corning Asia) and a catalyst were weighed at a weight ratio of 10:1, and the mixture was agitated gently, preventing incorporation of air as much as possible, to give a varnish. The varnish was poured into a tray gently to a depth of approximately 20 mm. The varnish was left still at room temperature for 24 hours, allowing solidification of the varnish, to give a surface-smooth microfluid-system-supporting unit.

### (Example 2)

An untacky adhesive S9009 (trade name, manufactured by Dow CorningAsia) was applied to a thickness of 0.40 mm at room temperature (25°C) onto one face of a substrate polyphenylene sulfide (PPS) film (Lumirror, registered trade name, manufactured by Toray Industries, Inc.) having a thickness of 0.06 mm, and the resulting film was cut into a piece of approximately 200 mm in length and 200 mm in width. Then, a PFA-fluorine-resin hollow filament (internal diameter: 0.79 mm, external diameter; 1.53 mm, manufactured by Iwase Co., Ltd.) was made available. The hollow filament of 1 m in length was placed and fixed on the untacky adhesive side of the substrate in a network shape formed by single continuous stroke in an NC wiring machine allowing application of load and ultrasonic wave, and the terminals thereof were exposed out of the substrate as the extra-length regions.

A polyurethane sealing tape (thickness: 10 mm, width: 15 mm, with adhesive, manufactured by Nitoms Inc.) was bonded to the substrate along its external edge, forming a bank. In the area where the polyurethane tape covers the hollow filament, the tape was fixed so tightly to the hollow filament that there is no opening between them. 300 g of a major agent ultrasoft urethane resin (manufactured by Exseal Corporation) and 100 g of a curing agent were weighed accurately (at a rate of 3:1), and the mixture was stirred uniformly in a stirrer, to give 400 g of a varnish. Then, the error in weight between the major agent and the curing agent was not larger than 1 wt percent. The varnish was poured inside the bank gently to a thickness of 5 mm. The varnish was left for 24 hours under a condition of a temperature of 25°C and a humidity of 80% or less, allowing solidification of the varnish. The solid (varnish) was a pale yellow, flexible and tacky substance having a compression strength (30%) of 7 kPa and a tensile elongation of 700%.

Subsequently, the adhesive S9009 was separated carefully from the substrate, to give a microfluid-system-supporting unit having the hollow filament retained in the solid.

The surface of the microfluid-system-supporting unit obtained was tacky (which was the property of solidified ultrasoft urethane resin). The microfluid-system-supporting unit was left still in a stainless steel pad, and a surface-coating agent (manufactured by Exseal Corporation) was applied with a brush on the area except the bottom face, and the unit was left at room temperature for about 3 hours. After confirmation that the surface-coating agent is hardened to some extent, the substrate was turned over; the surface-coating agent was applied similarly; and the unit was left at room temperature for about 3 hours, to give a microfluid-system-supporting unit having a untacky protective layer formed on the surface, which was superior in handling efficiency.

### (Example 3)

A double-faced adhesive tape (9415PC, trade name, manufactured by Sumitomo 3M) was cut into a piece of approximately 100 mm in length and 200 mm in width, and bonded onto an epoxy resin plate of 110 mm in length, 210 mm in width and 5 mm in thickness with the releasing film facing the epoxy resin plate, and the four corners thereof were fixed with a paper tape. Then, a polyether-imide hollow filament (internal diameter: 0.3 mm, external diameter: 0.5 mm, manufactured by Nirei Industry Co., Ltd.) was made available, and first hollow filaments were placed on the adhesive layer of the double-faced tape in a semicircular pattern at a curvature radius of approximately 20 mm in such a manner that the hollow filaments have a crossing region, in an NC wiring machine allowing application of load and ultrasonic wave. A sponge having a width of 10 mm and a height of 10 mm was made available and bonded to the double-faced tape as the bank in such a manner that it surrounds the hollow filaments. Then, the sponge was so bonded that the terminal of each hollow filament (about 50 mm in length) extends out of the bank as an extra-length region. The sponge was bonded so tightly in the area where the sponge covers the hollow filaments that there is no opening between them.

A major agent silicone elastomer SYLGARD 184 (trade name, manufactured by Dow Corning Asia) and a catalyst were weighed at a weight ratio of 10:1, and the mixture was stirred gently, preventing incorporation of air, to give a varnish. The varnish was poured inside the bank to a depth of approximately 5 mm and left still at normal temperature (25°C) for 24 hours, allowing solidification.

Then, the epoxy resin plate and the releasing film of the double-faced tape were separated from the substrate, and the adhesive layer of the double-faced tape was left on the surface of the solidified varnish. It was used as the substrate; PEEK tubes (internal diameter 0.10 mm, external diameter 0.25 mm) manufactured by Nirei Industry Co., Ltd. were placed in the parallel straight-chain pattern at a gap of 1.0 mm as the second hollow filaments; and additionally PFA tubes manufactured by Nissei Electric Co., Ltd. (internal diameter: 0. 70 mm, external diameter: 1. 00 mm) were placed crosswise to the secondhollow filaments inaparallel straight-chain pattern at an interval of 1.5 mm as the third hollow filaments.

A polyurethane sealing tape (thickness: 10 mm, width: 15 mm, with adhesive, manufactured by Nitoms Inc.) was bonded thereto in a manner that it surrounds the crossing region of the second and third hollow filaments placed on the substrate face, forming a bank.

The varnish used for fixing the first hollow filaments was poured inside the bank to a thickness of approximately 10 mm, and left at room temperature for 24 hours, allowing solidification, to give a microfluid-system-supporting unit.

### (Example 4)

A temporarily-fixing aluminum tube jig and 600 mm of a high-density polyethylene tube manufactured by Nirei Industry Co., Ltd. (internal diameter: 0.50 mm × external diameter: 1.00 mm) were made available. The temporarily-tube-fixing jig is cylinders of 3 mm in diameter and 15 mm in height formed on an aluminum plate of 250 mm in length, 150 mm in width, and 5 mm in thickness in the lattice form at intervals of 15 mm in the length and width directions. A nylon-6 tube was fixed with an adhesive tape on the cylinder, leaving the both ends thereof having a length of 100 mm exposed as the extra-length regions, vertically on the temporarily-tube-fixing jig. The other tube was guided through the cylinders in the temporarily-tape-fixing jig into a zigzag pattern. The composite was placed in a dryer previously heated to 100°C for 2 hours and then cooled at room temperature. After the adhesive tape was removed and the tube separated from the temporarily-tape-fixing jig, the tube had a region in the zigzag shape and extra-length regions extending in the perpendicular direction.

A SUS container of 300 mm in length, 200 mm in width, and 40 mm in depth was prepared, and a SUS square rod (side: 20 mm) was placed over the container. The tube above is placed in a container with its extra-length region sticking out of the container in the opening direction (above), and the extra-length regions were connected to the SUS square rod with an adhesive tape in such a manner that the entire tube floats in the container at a height of several mm from the bottom. A major agent silicone elastomer SYLGARD 184 (trade name, manufactured by Dow Corning Asia) and a catalyst were weighed at a weight ratio of 10:1, and the mixture was stirred carefully, preventing incorporation of air therein, to give a varnish. The varnish was poured into the container to a depth.of approximately 10 mm. It was left at normal temperature (25°C) for 24 hours, allowing solidification of the varnish, to give a fixing layer. Removal from the container gave a surface-smooth microfluid-system-supporting unit.

### (Example 5)

A SUS cylindrical rod having a diameter of 30 mm and 600 m of a nylon-6 tube manufactured by Nirei Industry Co. , Ltd. (internal diameter: 1.0 mm × external diameter: 1.59 mm) were made available. The positions 100 mm from both ends of the tube were marked for indication of extra-length regions. One terminal with an extra length of 100 mm was fixed with an adhesive tape to the SUS cylindrical rod in the machine direction, and the other tube was wound around the cylindrical rod in the coil shape and fixed with the adhesive tape, leaving the other extra-length terminal free. The unfixed extra-length terminal was fixed with the adhesive tape in parallel with the extra-length terminal in the direction identical therewith. The composite was placed in a dryer preheated to 100°C and then cooled at room temperature. Removal of the adhesive tape and separation from the cylindrical rod gave a tube in the coil shape.

A major agent silicone elastomer SYLGARD 184 (trade name, manufactured by Dow Corning Asia) and a catalyst were weighed at a weight ratio of 10:1, and the mixture was mixed carefully, preventing incorporation of air, to give a varnish. The varnish was placed in a plastic cup having an opening of 50 mm, a base of 40 mm, and a depth of 75 mm to a depth of 50 mm. The tube in the coil shape were held at both ends and immersed in the varnish in the plastic cup, gradually, preventing incorporation of air bubble in the coil-shaped region. The extra-length regions were fixed in such a manner that the tube did not become in contact with the plastic cup, and left at normal temperature (25°C) for 36 hours, allowing solidification of the varnish, to give a fixing layer. Separation from the plastic cup gave a surface-smooth microfluid-system-supporting unit.

The present invention has been described so far with reference to favorable embodiments, but it should be understood that the invention is not limited to the parts and the drawings of the disclosure. It would be easy for those skilled in the art to find various alternative embodiments, examples, and operational methods.

### Industrial Applicability

The present invention provides a microfluid-system-supporting unit lower in surface irregularity, more resistant to breakage or deformation in the hollow filament crossing regions and the regions where there are multiple hollow filaments different in external diameter during production of the microfluid-supporting unit than lamination methods, and resistant topositional deviationof the hollow filament in the crossing regions, and a production method thereof. It is possible to place a hollow filament in any pattern and thus to make the hollow filament cross itself. It is thus possible to increase the density of the hollow filament and to give a microfluid-system-supporting unit having channels at the cm order easily. It is also possible to give a microfluid-system-supporting unit smaller in surface irregularity and superior in flatness, even when the hollow filament crosses itself or two or more hollow filaments different in external diameter are used.

It is also possible to give a compact microfluid-system-supporting unit having multiple channels in a complicated fluid circuit but demanding smaller space, by making multiple hollow filaments cross each other.

Because it is possible to cover only a particular region of the hollow filament with a fixing layer, it is also possible to cover only a desirable region with a fixing layer, for example to prevent penetration of the varnish into the channel by covering the area of the hollow filament other than the terminal regions with a fixing layer of varnish, or to cover only the regions vulnerable to deformation by strong external force such as the crossing region and the region containing hollow filament having a larger external diameter and regions having a sensitive complicated pattern such as the region having a complicated pattern and high-density crossing region.

It is also possible to expose the intermediate region of the hollow filament and make it an observation window or a connection unit with other part, by removing part of the fixing layer. In forming the observation window, the hollow filament-exposed area may be as needed protected, by filling a high-transparency resin. Alternatively in forming the connection unit, the connection unit may be as needed protected after connection, by filling a resin. The fixing layer itself maybe made with a high-transparency material without forming the observation window.

The amount of the varnish for the fixing layer is variable, and thus, the thickness of the fixing layer is arbitrary. The thickness larger than the external diameter of all hollow filaments used is effective in giving a microfluid-system-supporting unit superior in flatness. Similarly, the thickness is preferably larger than the total thickness of the hollow filaments in the crossing region.

The hollow filaments are preferably fixed in the fixing layer, but a layer may be formed in a particular region other than the regions containing the hollow filaments on the substrate for protection from external force. In this way, it is possible to prevent chemical degradation of the hollow filament by the fixing layer and to make connection with other part and observation of the channel hollow filament easier. In such a case too, it is possible to give a more reliability microfluid-system-supporting unit by fixing part of the hollow filaments in the fixing layer.

It is also possible to prevent leaching of the varnish and cover only a particular region with the varnish by forming a bank, when a particular region is desirably coated. It is also possible to prevent mixing of varnishes when the substrate surface is covered with multiple kinds of varnishes.

Further, it is possible to select the thickness of the fixing layer freely by adjusting the height of the bank.

It is also possible to give a microfluid-system-supporting unit having a particular hollow filament region exposed or a microfluid-system-supporting unit having an exposed region other than that containing hollow filaments, by removing the substrate, fixing layer, varnish, or intermediate layer in a particular region after formation of the fixing layer.

## Claims

1. A microfluid-system-supporting unit, comprising a substrate and a fixing layer formed thereon, wherein part of at least one hollow filament is placed and fixed in any shape in the fixing layer.

2. The microfluid-system-supporting unit according to Claim 1, further comprising a protective layer covering at least part of the substrate and the fixing layer.

3. A microfluid-system-supporting unit, comprising a protective layer and a fixing layer formed thereon, wherein part of at least one hollow filament is placed and fixed in any shape in the fixing layer.

4. A microfluid-system-supporting unit, comprising an intermediate layer and a fixing layer formed thereon, wherein part of at least one hollow filament is placed and fixed in any shape in the fixing layer.

5. Amicrofluid-system-supporting unit, **characterized in that** part of at least one hollow filament is placed and fixed in any shape in a fixing layer.

6. The microfluid-system-supporting unit according to Claim 1 or 2, wherein an intermediate layer is formed between the substrate and the fixing layer.

7. The microfluid-system-supporting unit according to Claim 3, wherein an intermediate layer is formed between the protective layer and the fixing layer.

8. The microfluid-system-supporting unit according to any one of Claims 4, 6, and 7, wherein the intermediate layer is a layer having an adhering potential, a layer having a buffering potential, or a layer having a releasing potential.

9. The microfluid-system-supporting unit according to any one of Claims 1, 2, and 6, wherein the terminal of at least one hollow filament has an extra-length region sticking out of the substrate terminal.

10. The microfluid-system-supporting unit according to any one of Claims 2, 3, 6, and 7, wherein the terminal of at least one hollow filament has an extra-length region sticking out of the protective layer terminal.

11. The microfluid-system-supporting unit according to any one of Claims 1 to 10, wherein the terminal of at least one hollow filament has an extra-length region sticking out of the fixing layer terminal.

12. The microfluid-system-supporting unit according to any one of Claims 1 to 11, wherein at least part of the external wall of the intermediate region of at least one hollow filament is exposed out of the fixing layer.

13. The microfluid-system-supporting unit according to Claim 12, wherein at least part of the external wall of the intermediate region of at least one hollow filament is exposed out of the protective layer.

14. The microfluid-system-supporting unit according to any one of Claims 1 to 11, wherein the external wall of the intermediate region of at least one hollow filament is not exposed out of the fixing layer.

15. The microfluid-system-supporting unit according to any one of Claims 1 to 14, wherein the number of the hollow filaments is two or more.

16. The microfluid-system-supporting unit according to Claim 15, wherein the two or more hollow filaments are hollow filaments having two or more different external diameters.

17. The microfluid-system-supporting unit according to any one of Claims 1 to 16, wherein at least one hollow filament is placed in such a manner that it has a crossing region.

18. The microfluid-system-supporting unit according to any one of Claims 1 to 17, wherein the thickness of the microfluid-system-supporting unit in the region containing hollow filaments is larger than the external diameter of all hollow filaments.

19. The microfluid-system-supporting unit according to any one of Claims 1 to 18, wherein the thickness of the microfluid-system-supporting unit in the region containing hollow filaments is larger than the total thickness of the hollow filaments in the crossing region.

20. The microfluid-system-supporting unit according to any one of Claims 1 to 19, wherein the surface of the microfluid-system-supporting unit in the region containing hollow filaments is smooth.

21. The microfluid-system-supporting unit according to any one of Claims 1 to 20, wherein the fixing layer is a solidified varnish.

22. The microfluid-system-supporting unit according to Claim 21, wherein the varnish before solidification is fluid.

23. The microfluid-system-supporting unit according to any one of Claims 1 to 22, wherein the thickness of the microfluid-system-supporting unit in the region containing hollow filaments is 100 to 120% of the thickness of the microfluid-system-supporting unit in the region containing no hollow filament.

24. The microfluid-system-supporting unit according to any one of Claims 1 to 22, wherein the thickness of the microfluid-system-supporting unit in the region containing hollow filaments is 100 to 110% of the thickness of the microfluid-system-supporting unit in the region containing no hollow filament.

25. The microfluid-system-supporting unit according to any one of Claims 1 to 22, wherein the thickness of the microfluid-system-supporting unit in the region containing hollow filaments is 100 to 105% of the thickness of the microfluid-system-supporting unit in the region containing no hollow filament.

26. The microfluid-system-supporting unit according to any one of Claims 1 to 22, wherein the thickness of the microfluid-system-supporting unit in the region containing hollow filaments is 100 to 103% of the thickness of the microfluid-system-supporting unit in the region containing no hollow filament.

27. The microfluid-system-supporting unit according to any one of Claims 1 to 26, wherein at least one hollow filament is placed in such a manner that it has a crossing region and the thickness of the microfluid-system-supporting unit in the crossing region is 100 to 120% of the thickness of the microfluid-system-supporting unit in the region other than the crossing region where the hollow filament is placed.

28. The microfluid-system-supporting unit according to any one of Claims 1 to 26, wherein at least one hollow filament is placed in such a manner that it has a crossing region and the thickness of the microfluid-system-supporting unit in the crossing region is 100 to 110% of the thickness of the microfluid-system-supporting unit in the region other than the crossing region where the hollow filament is placed.

29. The microfluid-system-supporting unit according to any one of Claims 1 to 26, wherein at least one hollow filament is placed in such a manner that it has a crossing region and the thickness of the microfluid-system-supporting unit in the crossing region is 100 to 105% of the thickness of the microfluid-system-supporting unit in the region other than the crossing region where the hollow filament is placed.

30. The microfluid-system-supporting unit according to any one of Claims 1 to 26, wherein at least one hollow filament is placed in such a manner that it has a crossing region and the thickness of the microfluid-system-supporting unit in the crossing region is 100 to 103% of the thickness of the microfluid-system-supporting unit in the region other than the crossing region where the hollow filament is placed.

31. A method of producing a microfluid-system-supporting unit, comprising at least the following steps of:
(i) placing at least one hollow filament in any shape on a substrate,
(ii) covering a particular region including at least part of the hollow filament with a varnish, and
(iii) solidifying all or part of the varnish.

32. A method of producing a microfluid-system-supporting unit, comprising at least the following steps of:
(i) placing at least one hollow filament in any shape on a substrate,
(ii) covering a particular region including at least part of the hollow filament with a varnish,
(iii) solidifying all or part of the varnish, and
(iv) forming a protective layer in a particular region.

33. A method of producing a microfluid-system-supporting unit, comprising at least the following steps of:
(v) covering a particular region of a substrate with a varnish
(vi) immersing at least part of at least one hollow filament in the varnish or floating at least one hollow filament on the varnish, and
(vii) solidifying all or part of the varnish.

34. A method of producing a microfluid-system-supporting unit, comprising at least the following steps of:
(v) covering a particular region of a substrate with a varnish,
(vi) immersing at least part of at least one hollow filament in the varnish or floating at least one hollow filament on the varnish,
(vii) solidifying all or part of the varnish, and
(viii) forming a protective layer in a particular region.

35. Amethodof producing a microfluid-system-supporting unit, comprising at least the following steps of:
(ix) filling a varnish into a container,
(vi) immersing at least part of at least one hollow filament in the varnish or floating at least one hollow filament on the varnish,
(vii) solidifying all or part of the varnish, and
(x) removing at least part of the container.

36. A method of producing a microfluid-system-supporting unit, comprising at least the following steps of:
(ix) filling a varnish into a container,
(vi) immersing at least part of at least one hollow filament in the varnish or floating at least one hollow filament on the varnish,
(vii) solidifying all or part of the varnish,
(x) removing at least part of the container, and
(viii) forming a protective layer in a particular region.

37. A method of producing a microfluid-system-supporting unit, comprising at least the following steps of:
(ix) filling a varnish into a container,
(vi) immersing at least part of at least one hollow filament in the varnish or floating at least one hollow filament on the varnish,
(vii) solidifying all or part of the varnish,
(viii) forming a protective layer on the surface of the solidified varnish, and
(x) removing at least part of the container.

38. The method of producing a microfluid-system-supporting unit according to Claim 31 or 32, further comprising a step of forming an intermediate layer between the substrate and at least one hollow filament before placing the at least one hollow filament on the substrate.

39. The method of producing a microfluid-system-supporting unit according to Claim 33 or 34, further comprising a step of forming an intermediate layer on the substrate before coating a particular region of the substrate with the varnish.

40. The method of producing a microfluid-system-supporting unit according to any one of Claims 35 to 37, further comprising a step of forming an intermediate layer on the surface of a container before filling the varnish in the container.

41. The method of producing a microfluid-system-supporting unit according to any one of Claims 38 to 40, further comprising a step of placing all or part of the at least one hollow filament in any shape on the intermediate layer.

42. The method of producing a microfluid-system-supporting unit according to any one of Claims 38 to 41, wherein the intermediate layer is a layer having an adhering potential, a layer having a buffering potential, or a layer having a releasing potential.

43. The method of producing a microfluid-system-supporting unit according to any one of Claims 31 to 34, wherein a bank is formed and a particular region is covered with the varnish.

44. The method of producing a microfluid-system-supporting unit according to any one of Claims 38 to 43, further comprising a step of removing at least part of the intermediate layer after all or part of the varnish is solidified.

45. The method of producing a microfluid-system-supporting unit according to any one of'Claims 31 to 34, 38, 39, and 42 to 44, further comprising a step of removing at least part of the substrate after all or part of the varnish is solidified.

46. The method of producing a microfluid-system-supporting unit according to any one of Claims 33 to 45, wherein the hollow filament previously fixed in any shape is immersed in the varnish or floated on the varnish.

47. The method of producing a microfluid-system-supporting unit according to Claim 46, wherein the hollow filament is placed and fixed previously on the substrate or the intermediate layer of the substrate having it.

48. The method of producing a microfluid-system-supporting unit according to any one of Claims 33 to 37, wherein the hollow filament is fixed in any shape in the varnish.

49. The method of producing a microfluid-system-supporting unit according to any one of Claims 31 to 48, wherein the varnish is fluid.

50. The method of producing a microfluid-system-supporting unit according to any one of Claims 31 to 49, further comprising a step of removing the varnish.
